# EUROPÄISCHE PATENTSCHRIFT

(11) **EP 3 415 875 B1**
(45) Veröffentlichungstag und Bekanntmachung des Hinweises auf die Patenterteilung: **16.03.2022**
(21) Anmeldenummer: 18174700.7
(22) Anmeldetag: 29.05.2018
(51) Int. Cl.: G01F 1/58, G01F 15/02, G01F 15/18, G01R 33/028, H01H 36/00, G01R 33/07, G01P 15/00

(54) **MAGNETISCH-INDUKTIVES DURCHFLUSSMESSGERÄT UND VERFAHREN ZUM BETREIBEN EINES MAGNETISCH-INDUKTIVEN DURCHFLUSSMESSGERÄTS**
MAGNETIC-INDUCTIVE FLOW MEASURING DEVICE AND METHOD FOR OPERATING A MAGNETIC-INDUCTIVE FLOW MEASURING DEVICE
DÉBITMÈTRE MAGNÉTO-INDUCTIF ET PROCÉDÉ DE FONCTIONNEMENT D'UN DÉBITMÈTRE MAGNÉTO-INDUCTIF

(30) Priorität: 13.06.2017 DE 102017112950
(43) Veröffentlichungstag der Anmeldung: 19.12.2018
(73) Patentinhaber: Krohne Messtechnik GmbH, 47058 Duisburg (DE)
(72) Erfinder: Brockhaus, Helmut, 46145 Oberhausen (DE); Florin, Wilhelm, 47198 Duisburg (DE)
(74) Vertreter: Gesthuysen Patentanwälte

(56) Entgegenhaltungen:
- EP-A1- 3 208 580
- WO-A1-96/18086
- DE-A1- 19 713 751
- US-A- 4 159 645
- US-A- 4 236 410

## Beschreibung

Die Erfindung betrifft ein magnetisch-induktives Durchflussmessgerät zur Messung des Durchflusses eines leitfähigen Mediums, mit einem Messrohr, mit einer Magnetfelderzeugungsrichtung zur Erzeugung eines das Messrohr durchsetzenden Messmagnetfeldes, mit einer Magnetkreisvorrichtung zur Führung des Messmagnetfeldes außerhalb des Messrohres, mit Elektroden zur Erfassung einer durchflussabhängigen elektrischen Messspannung bei Durchströmen des Messrohres mit einem leitfähigen Medium und mit einer elektronischen Steuer- und Auswerteeinrichtung. Die Erfindung betrifft ferner ein Verfahren zum Betreiben eines magnetisch-induktiven Durchflussmessgerätes.

Gattungsgemäße magnetisch-induktive Durchflussmessgeräte sind aus dem Stand der Technik bekannt und dienen zur Bestimmung des Durchflusses eines Mediums, siehe z.B. DE275683 oder US4159645. Hierzu erzeugt die Magnetfelderzeugungseinrichtung ein Magnetfeld, das das im Messrohr befindliche elektrisch leitfähige Medium zumindest teilweise durchsetzt. Aufgrund der Strömung des Mediums im Messrohr wird durch Ladungstrennung eine Induktionsspannung in dem Medium induziert, die von den Elektroden abgegriffen wird. Die Messspannung ergibt sich dann aus der eigentlich interessierenden aufgrund der Ladungstrennung in dem Medium induzierten Induktionsspannung und aus Störspannungen, die beispielsweise aus einem zeitlich veränderlichen magnetischen Fluss in der durch die Elektroden, die Elektrodenkabel und das elektrisch leitfähige Medium gebildeten Leiterschleife resultieren. Die Messspannung ist proportional zur Strömungsgeschwindigkeit des Mediums in dem Messrohr. Mit der Strömungsgeschwindigkeit des Mediums und dem Durchmesser des Messrohres lässt sich dann der Durchfluss - Volumendurchfluss oder Massedurchfluss bei bekannter Dichte - des Mediums bestimmen. Gattungsgemäße magnetisch-induktive Durchflussmessgeräte weisen neben der Magnetfelderzeugungseinrichtung ebenfalls eine Magnetkreisvorrichtung auf. Diese Magnetkreisvorrichtung dient zur Führung des Messmagnetfeldes außerhalb des Messrohres sowie zur Konzentration des Messmagnetfeldes auf den Bereich des Messrohres und ist in der Regel aus einem weichmagnetischen Material gefertigt.

Da der Durchfluss des Mediums durch das Messrohr aus der Messspannung bestimmt wird und die Messspannung proportional zur Strömungsgeschwindigkeit des Mediums im Messrohr und zur Messmagnetfeldstärke im Medium ist, ist es entscheidend, die Feldstärke des magnetischen Feldes im Inneren des Messrohres mit hoher Wiederholgenauigkeit zu erzeugen und zwar über die gesamte Lebensdauer des Messinstruments. Eine hohe Anfangsgenauigkeit wird in der Regel dadurch erreicht, dass die Messgeräte mit Durchfluss "nass" kalibriert werden. Zur Erzielung einer großen Wiederholgenauigkeit ist unter anderem dafür Sorge zu tragen, dass sich das magnetische Feld in der Anwendung nicht mehr ändert und andere Störeffekte unterdrückt werden. Bekannte Störeinflüsse sind elektrochemische Störspannungen, Netzstörspannungen und Induktionsspannungen in der Leiterschleife des Messkreises. Zur Unterdrückung von Störeinflüssen ist es im Stand der Technik bekannt, magnetisch-induktive Durchflussmessungen mit geschaltetem magnetischen Gleichfeld oder einem magnetischen Wechselfeld durchzuführen. Die Messung der an den Elektroden induzierten Messspannung erfolgt hierbei phasensynchron mit der Feldumschaltung.

Eine Beeinflussung der Durchflussmessung erfolgt jedoch nicht nur durch direkte Einflüsse, wie beispielsweise das überlagernde äußere Magnetfeld, sondern ebenfalls durch indirekte Einflüsse. Indirekte Einflüsse sind solche Einflüsse, die die Eigenschaften der Magnetkreisvorrichtung verändern. Eine Veränderung der Eigenschaften der Magnetkreisvorrichtung resultiert zwangsläufig in einer Veränderung des Messmagnetfeldes und damit einer Veränderung der Messspannung. Indirekte Einflüsse sind hierbei insbesondere eine Sättigung der Magnetkreisvorrichtung aufgrund äußerer auf die Magnetkreisvorrichtung wirkender Magnetfelder, eine Änderung der Permeabilität der Magnetkreisvorrichtung durch den Einfluss bzw. eine Änderung der Temperatur der Magnetkreisvorrichtung sowie mechanische Veränderungen der Magnetkreisvorrichtung beispielsweise durch Vibrationen.

Aus dem Stand der Technik ist es bekannt, eine Sättigung der Magnetkreisvorrichtung durch eine Überdimensionierung derselben sowie durch magnetische Abschirmung zu verhindern. Der Effekt der Temperatur wird im Stand der Technik durch die Verwendung von hochwertigen Materialien gelöst, die nur eine geringe Abhängigkeit der Permeabilität von der Temperatur aufweisen. Problematisch an den bekannten Lösungen sind zum einen die extrem hohen Herstellungskosten aufgrund der Verwendung von hochwertigen Materialien und zum anderen die aus der Überdimensionierung der Magnetkreisvorrichtung resultierenden schweren sowie großbauenden Durchflussmessgeräte.

Der Erfindung liegt demnach die Aufgabe zugrunde, ein magnetisch-induktives Durchflussmessgerät anzugeben, das eine kleinere und preisgünstigere Bauweise aufweist, als die aus dem Stand der Technik bekannten magnetisch-induktiven Durchflussmessgeräte. Ebenfalls liegt der Erfindung die Aufgabe zugrunde, ein Verfahren zum Betreiben eines solchen magnetisch-induktiven Durchflussmessgerätes anzugeben.

Die Aufgabe ist bei dem erfindungsgemäßen magnetisch-induktiven Durchflussmessgerät zunächst und im Wesentlichen dadurch gelöst, dass an der Magnetkreisvorrichtung ein Sensor zur Erfassung einer auf die Magnetkreisvorrichtung wirkenden physikalischen Störgröße angeordnet ist, wobei das Messmagnetfeld durch diese physikalische Störgröße beeinflusst wird. Die Steuer- und Auswerteeinrichtung des erfindungsgemäßen magnetisch-induktiven Durchflussmessgerätes ist derart ausgestaltet, dass sie ein Überschreiten eines vorgebbaren Grenzwertes der physikalischen Störgröße erkennt und signalisiert. Das erfindungsgemäße magnetisch-induktive Durchflussmessgerät zeichnet sich also zunächst durch einen Sensor an der Magnetkreisvorrichtung aus, mit dem die auf die Magnetkreisvorrichtung wirkende physikalische Störgröße erfasst werden kann, bevorzugt sowohl ihrer Art als auch ihrer Größe nach. Durch die Erfassung der physikalischen Störgröße wird ermöglicht, die Auswirkung der Störgröße auf die Durchflussmessung zu erkennen und zu korrigieren. Der Sensor zur Erfassung der physikalischen Störgröße kann dabei mittelbar oder unmittelbar mit der Magnetkreisvorrichtung verbunden sein.

Der Sensor ist bevorzugt von außen an der Magnetkreisvorrichtung angeordnet. Wenn es heißt, dass der Sensor von außen an der Magnetkreisvorrichtung angeordnet ist, dann ist der Sensor an der dem Messrohr abgewandten Seite des Magnetkreises angeordnet, also auf der nach außen zeigenden Fläche des Magnetkreises angeordnet. Der Sensor befindet sich also außerhalb des Magnetkreises.

In einer Ausgestaltung ist ein Grenzwert für die physikalische Störgröße vorgegeben. Dieser Grenzwert kann beispielsweise in der Steuer- und Auswerteeinheit abgelegt sein. Der Grenzwert beschreibt denjenigen Wert der physikalischen Störgröße, bei dem die Auswirkungen der Störgröße auf die Durchflussmessung derartig groß sind, dass die Messung verworfen werden sollte oder jedenfalls signalisiert werden sollte, dass die Vertrauenswürdigkeit des erhaltenen Messwertes zweifelhaft ist. Verworfen werden sollte, bzw. unbrauchbar geworden ist eine Durchflussmessung in diesem Zusammenhang dann, wenn der Durchflussmesswert aufgrund der Auswirkung der physikalischen Störgröße auf die Durchflussmessung derartig verfälscht ist, dass eine tolerierbare Abweichung von dem tatsächlichen Durchflusswert überschritten ist. Dieser Grenzwert ist beispielsweise von einem Benutzer bestimmbar. Wird von dem Sensor ein Wert der physikalischen Störgröße erfasst, der den vorgegebenen Grenzwert überschreitet, so wird ein Überschreiten des Grenzwertes von der Steuer- und Auswerteeinrichtung erkannt und signalisiert. Der Benutzer weiß dann, dass das Ergebnis der Durchflussmessung keine zuverlässige Aussage über den tatsächlichen Durchfluss zulässt und kann die Messung verwerfen. Ebenfalls signalisiert werden kann auch ein Unterschreiten eines vorgegebenen Grenzwertes. Vorgegeben werden kann also ein oberer Grenzwert für die physikalische Störgröße oder ein unterer Grenzwert für die physikalische Störgröße. Ebenfalls können vorgegeben werden sowohl ein oberer als auch ein unterer Grenzwert für die physikalische Störgröße. Sind sowohl ein oberer als auch ein unterer Grenzwert vorgegeben, so wird sowohl ein Überschreiten des oberen als auch ein Unterschreiten des unteren Grenzwertes erkannt und signalisiert.

Die Steuer- und Auswerteeinrichtung kann zusätzlich derart ausgestaltet sein, dass sie eine Korrektur der Auswirkung der physikalischen Störgröße auf die Durchflussmessung durchführt. Wie genau eine solche Korrektur der Auswirkung der physikalischen Störgröße aussehen kann, wird in Zusammenhang mit dem erfindungsgemäßen Verfahren zum Betreiben des magnetisch-induktiven Durchflussmessgerätes ausgeführt. Insgesamt kann die Steuer- und Auswerteeinheit also derart ausgestaltet sein, dass sie sowohl ein Überschreiten oder Unterschreiten eines vorgebbaren Grenzwertes der physikalischen Störgröße erkennt und signalisiert und eine Korrektur der Auswirkung der physikalischen Störgröße auf die Durchflussmessung durchführt, oder dass sie lediglich ein Überschreiten oder Unterschreiten eines vorgebbaren Grenzwertes der physikalischen Störgröße erkennt.

Das erfindungsgemäße magnetisch-induktive Durchflussmessgerät unterscheidet sich also von den aus dem Stand der Technik bekannten magnetisch-induktiven Durchflussmessgeräten insbesondere dadurch, dass nicht die Auswirkungen der physikalischen Störgröße direkt aufgrund der Bauweise des magnetisch-induktiven Durchflussmessgerätes kompensiert werden, sondern dass die physikalische Störgröße zunächst überhaupt ermittelt wird. Die Durchflussmessung geschieht also bei dem erfindungsgemäßen magnetisch-induktiven Durchflussmessgerätes dennoch unter Einfluss der physikalischen Störgröße. Ist die physikalische Störgröße zu groß, bzw. sind die Auswirkun-gen der physikalischen Störgröße auf die Durchflussmessung zu eklatant, kann die Durchflussmessung von einem Benutzer verworfen werden, sofern die Steuer- und Auswerteeinheit ein Überschreiten oder Unterschreiten eines Grenzwertes der physikalischen Störgröße erkennt und signalisiert.

Ebenfalls denkbar bei dem erfindungsgemäßen magnetisch-induktiven Durchflussmessgerät ist, dass die Auswirkung der physikalischen Störgröße auf die Durchflussmessung korrigiert wird. Es wird erfindungsgemäß also nicht konstruktiv verhindert, dass die Durchflussmessung gestört wird, sondern die Auswirkungen der Störung werden im Nachhinein, bei der Bestimmung des Durchflusses korrigiert. Das erfindungsgemäße magnetisch-induktive Durchflussmessgerät weist also den Vorteil auf, dass keine neue, insbesondere sehr aufwendige, teure oder überdimensionierte Bauweise des magnetisch-induktiven Durchflussmessgerätes, insbesondere der Magnetkreisvorrichtung notwendig ist. Vielmehr kann das erfindungsgemäße magnetisch-induktive Durchflussmessgerät eine kleine Bauweise aufweisen und zudem preisgünstig hergestellt werden. Ebenfalls möglich ist die Aufrüstung bereits vorhandener magnetisch-induktiver Durchflussmessgeräte zu dem erfindungsgemäßen magnetisch-induktiven Durchflussmessgerät durch Anordnung eines Sensors zur Erfassung auf die Magnetkreisvorrichtung wirkender physikalischer Störgrößen an der Magnetkreisvorrichtung.

Eine bevorzugte Ausgestaltung des erfindungsgemäßen magnetisch-induktiven Durchflussmessgerätes ist dadurch gekennzeichnet, dass der Sensor als Temperatursensor ausgestaltet ist und zur Erfassung der Temperatur der Magnetkreisvorrichtung dient. Eine Veränderung der Temperatur der Magnetkreisvorrichtung führt zu einer Veränderung der Permeabilität der Magnetkreisvorrichtung, also zu einer Veränderung der Durchlässigkeit der Magnetkreisvorrichtung für magnetische Felder. Eine veränderte Permeabilität resultiert demnach in einem veränderten Messmagnetfeld. Eine Veränderung der Temperatur der Magnetkreisvorrichtung kann beispielsweise durch eine Veränderung der Mediumtemperatur bedingt sein. Durch eine Veränderung der Mediumtemperatur ändert sich auch die Temperatur des Messrohres, durch das das Medium fließt. Da das Messrohr und die Magnetkreisvorrichtung in Kontakt - insbesondere in thermischem Kontakt - miteinander stehen, wirkt sich eine Veränderung der Mediumtemperatur auch auf die Temperatur der Magnetkreisvorrichtung aus. Ebenfalls kann sich die Umgebungstemperatur des magnetisch-induktiven Durchflussmessgerätes verändern. Diese Veränderung wirkt sich unmittelbar auf die Temperatur der Magnetkreisvorrichtung aus. Der erfindungsgemäße Temperatursensor ist unmittelbar oder mittelbar mit der Magnetkreisvorrichtung verbunden.

In einer Ausgestaltung ist ein Grenzwert für die Temperatur der Magnetkreisvorrichtung vorgegeben. Der Grenzwert beschreibt denjenigen Temperaturwert, bei dem die Auswirkungen der Temperaturveränderungen auf die Durchflussmessung derartig groß sind, dass die Messung unbrauchbar geworden ist bzw. eine nicht mehr tolerable Ungenauigkeit aufweist. Wird von dem Temperatursensor ein Temperaturwert erfasst, der den vorgegebenen Grenzwert überschreitet, weist die Magnetkreisvorrichtung also eine Temperatur oberhalb einer maximal tolerierbaren Temperatur auf, so wird ein Überschreiten des Grenzwertes von der Steuer- und Auswerteeinrichtung erkannt und signalisiert. Ebenfalls signalisiert wird ein Unterschreiten eines vorgegebenen Grenzwertes. Auch durch ein Abkühlen der Magnetkreisvorrichtung auf eine Temperatur unterhalb einer tolerierbaren Magnetkreistemperatur wird die Durchflussmessung verfälscht, da mit einem Abkühlen ebenso wie mit einem Erwärmen eine Änderung der Permeabilität der Magnetkreisvorrichtung und damit eine Veränderung des Messmagnetfeldes einhergeht.

Alternativ oder zusätzlich ist ebenfalls möglich, dass eine Korrektur der Auswirkung der Temperatur der Magnetkreisvorrichtung auf die Durchflussmessung durchgeführt wird. Im Zusammenhang mit der Korrektur der Auswirkung der Temperatur wird ebenfalls verwiesen auf die Ausführungen in Verbindung mit dem erfindungsgemäßen Verfahren. Ist die Steuer- und Auswerteeinheit derart ausgestaltet, dass sie sowohl ein Überschreiten oder Unterschreiten eines vorgegebenen Temperaturwertes erkennt und signalisiert und eine Korrektur der Auswirkungen der Temperatur auf die Durchflussmessung durchführt, wird eine Korrektur der Auswirkung der Temperatur bevorzugt dann durchgeführt, wenn die Grenzwerte noch nicht über- oder unterschritten sind.

Eine besonders bevorzugte Ausgestaltung des erfindungsgemäßen magnetisch-induktiven Durchflussmessgerätes ist dadurch gekennzeichnet, dass der Sensor als Magnetfeldsensor ausgestaltet ist und zur Erfassung eines äußeren, auf die Magnetkreisvorrichtung wirkenden Magnetfeldes dient. Besonders bevorzugt ist der Magnetfeldsensor hierbei als Hall-Sensor ausgestaltet. Die Verwendung eines Hall-Sensors ist deshalb besonders bevorzugt, weil ein solcher Sensor eine Richtungsabhängigkeit aufweist. Ein Hall-Sensor ist demnach lediglich empfindlich für ein Magnetfeld in einer bestimmten Raumrichtung, bzw. auf eine Komponente eines Magnetfeldes entlang einer Raumrichtung. Ein äußeres auf die Magnetkreisvorrichtung wirkendes Magnetfeld kann den Einfluss haben, dass es zu einer Sättigung der Magnetkreisvorrichtung in Richtung des äußeren Magnetfeldes kommt. Ein Einfluss eines äußeren Magnetfeldes ist jedoch nicht nur dann störend, wenn es zu einer Sättigung der Magnetkreisvorrichtung, sondern auch dann, wenn es zu "irgendeiner" Ausrichtung der magnetischen Momente der Magnetkreisvorrichtung in dem äußeren Magnetfeld kommt. Ein Ausrichten der magnetischen Momente der Magnetkreisführung in dem äußeren Magnetfeld führt unweigerlich zu einer Beeinflussung des Messmagnetfeldes und damit zu einer Beeinflussung bzw. Störung der Durchflussmessung. Die Auswirkungen des äußeren Magnetfelds auf die Durchflussmessung sind hierbei nicht nur abhängig von der Stärke des äußeren Magnetfeldes, sondern ebenfalls von der Richtung des äußeren Magnetfeldes.

In einer bevorzugten Ausgestaltung ist die Steuer- und Auswerteeinheit derart ausgestaltet, dass sie eine Korrektur der Auswirkungen des äußeren Magnetfeldes auf die Durchflussmessung durchführt. Auch im Zusammenhang mit der Korrektur der Auswirkungen des äußeren Magnetfeldes wird auf die Ausführungen im Zusammenhang mit dem erfindungsgemäßen Verfahren verwiesen. Ist die Steuer- und Auswerteeinheit derart ausgestaltet, dass sie ein Überschreiten eines vorgebbaren Grenzwertes des äußeren Magnetfeldes erkennt und signalisiert, bzw. ist die Steuer- und Auswerteeinheit derart ausgestaltet, dass sie lediglich ein Überschreiten eines Grenzwertes erkennt und signalisiert, dann bietet sich in einer besonders bevorzugten Ausgestaltung des erfindungsgemäßen magnetisch-induktiven Durchflussmessgerätes an, dass der Sensor als Magnetfeldschalter ausgebildet ist und zur Erfassung des äußeren auf die Magnetkreisvorrichtung wirkenden Magnetfeldes dient. Bei der Verwendung eines Magnetfeldsensors bzw. eines Magnetfeldschalters wird bevorzugt nur ein oberer Grenzwert bestimmt, da im Idealfall kein äußeres Magnetfeld auf die Magnetkreisvorrichtung wirkt, ein unterer Grenzwert demnach keinen Nutzen hat. Ein Überschreiten eines vorgegebenen Grenzwertes kann dadurch signalisiert werden, dass ein definierter Fehlerzustand eingenommen wird.

Eine besonders bevorzugte Ausgestaltung des erfindungsgemäßen magnetisch-induktiven Durchflussmessgerätes ist dadurch gekennzeichnet, dass der Sensor als Beschleunigungssensor ausgestaltet ist. Der Sensor dient hierbei zur Erfassung einer Beschleunigung der Magnetkreisvorrichtung. Diese Beschleunigung wird insbesondere durch Vibrationen hervorgerufen. Diese Vibrationen werden beispielsweise durch eine mit dem magnetisch-induktiven Durchflussmessgerät verbundene Pumpe erzeugt und eingespeist. Die Vibrationen können jedoch auch von anderen Bauteilen übertragen werden. Auf das magnetisch-induktive Durchflussmessgeräte wirkende Vibrationen, oder allgemein gesagt auf das magnetisch-induktive Durchflussmessgerät wirkende Beschleunigungen können verschiedene Einflüsse haben, die sich negativ auf die Durchflussmessung auswirken können.

Zum einen können die Vibrationen direkt auf die Magnetkreisvorrichtung übertragen werden, was zu einer mechanischen Bewegung der Magnetkreisvorrichtung führt. Je nach Stärke der Vibrationen, also je nach Höhe der Amplitude der Vibrationen, kann das dazu führen, dass es zu einer Verschiebung der Magnetkreisvorrichtung relativ zu dem Messrohr kommt. Tritt dieser Fall ein, dann ist die Gültigkeit einer vorher durchgeführten Kalibration des Durchflussmessgerätes fraglich, die Richtigkeit der Durchflussmesswerte muss demnach ebenfalls in Frage gestellt werden.

Zum anderen können mechanische Schwingungen auf die zu den Elektroden führenden Kabel übertragen werden. Die Kabel sind in der Regel Koaxialkabel. Durch mechanische Schwingungen und damit einhergehende Deformation der Kabel ändert sich die Kapazität im Kabel (Mikrofonieeffekt). Das führt zu einer Veränderung der elektrischen Messspannung, die von den Elektroden abgegriffen wird, bzw. zu einer Veränderung des gemessenen Signals. Bei bevorzugten magnetisch-induktiven Durchflussmessgeräten liegt die Messfrequenz zwischen 20 und 60 Hz. Insbesondere von Pumpen herrührende Vibrationen liegen oft in der Größenordnung bis 100 Hz, fallen also direkt in den Bereich der Messfrequenz.

Ebenfalls kann durch eine Bewegung der zu den Elektroden führenden Kabel eine störende Induktionsspannung induziert werden, wenn die durch die Kabel gebildete Leiterschleife mit einem äußeren Magnetfeld (oder auch mit dem Messmagnetfeld) durchsetzt ist. Diese störende Induktionsspannung bildet dann einen Teil der Messspannung. Durch die Anordnung eines Beschleunigungssensors und der damit ermöglichten Erfassung der Beschleunigung der Magnetkreisvorrichtung können die Schwingungen - indirekt auch benachbarter Bauteile - erfasst werden, sodass eine Korrektur der Auswirkung der Schwingung auf die Durchflussmessung ermöglicht wird.

In einer Ausgestaltung ist die Steuer- und Auswerteeinheit derart ausgestaltet, dass sie ein Überschreiten eines vorgegebenen Grenzwertes für die Vibrationen - also insbesondere ein Überschreiten einer vorgegebenen Amplitude der Vibrationen - erkennt und signalisiert. Ist der Sensor, wie in der hier beschriebenen Ausgestaltung des magnetisch-induktiven Durchflussmessgerätes als Beschleunigungssensor ausgebildet, dann wird bevorzugt nur ein oberer Grenzwert vorgegeben, da bevorzugt keine Vibrationen an der Magnetkreisvorrichtung messbar sind, ein unterer Grenzwert also keinen Nutzen hat. Der Grenzwert ist der Wert, bei dem die mechanische Stabilität des magnetisch- induktiven Durchflussmessgerätes gerade noch gewährleistet ist, bei dem es also nicht zu einer Verschiebung des Magnetkreises relativ zu dem Messrohr kommt. Wird dieser Grenzwert überschritten, kann auch keine Korrektur der Auswirkung der Vibrationen auf die Durchflussmessung mehr erfolgen, da das System insgesamt nicht mehr kalibriert ist. Wird jedoch ein Wert, insbesondere ein Wert für die Amplitude der Beschleunigung bzw. der Vibrationen erfasst, der unterhalb des vorgegebenen Grenzwertes liegt, dann kann eine Korrektur der Auswirkung der Beschleunigung auf die Durchflussmessung durchgeführt werden. Zur Spezifizierung der Korrektur wird auch in diesem Zusammenhang auf die nachfolgenden Beschreibungen im Zusammenhang mit dem erfindungsgemäßen Verfahren verwiesen.

Eine weitere Ausgestaltung des magnetisch-induktiven Durchflussmessgerätes zeichnet sich dadurch aus, dass wenigstens ein weiterer Sensor an der Magnetkreisvorrichtung angeordnet ist. Dieser weitere Sensor ist insbesondere als Temperatursensor, als Magnetfeldsensor, als Magnetfeldschalter oder als Beschleunigungssensor ausgestaltet. Weiter bevorzugt dient der weitere an der Magnetkreisvorrichtung angeordnete Sensor zur Erfassung einer auf die Magnetkreisvorrichtung wirkenden physikalischen Störgröße, die sich von der Störgröße unterscheidet, die der erste Sensor erfasst. Hierdurch ist es möglich, dass verschiedene auf die Magnetkreisvorrichtung wirkende Einflüsse erfasst werden können. Die Korrekturen der Auswirkungen der verschiedenen physikalischen Störgrößen auf die Durchflussmessung können dann getrennt voneinander ausgeführt werden. Ebenfalls denkbar ist eine Ausführungsform eines magnetisch-induktiven Durchflussmessgerätes, bei der der erste Sensor als Magnetfeldsensor ausgestaltet ist und der wenigstens eine weitere Sensor ebenfalls als Magnetfeldsensor ausgestaltet ist. Die beiden Magnetfeldsensoren sind dann derart an der Magnetkreisvorrichtung angeordnet, dass sie sensitiv für verschiedene Komponenten des äußeren Magnetfeldes sind. Der erste Sensor erfasst insbesondere eine Komponente des äußeren Magnetfeldes, die in eine erste Richtung wirkt, und der zweite Magnetfeldsensor erfasst eine Komponente des äußeren Magnetfeldes, die in eine zweite, von der ersten Raumrichtung verschiedene Raumrichtung wirkt.

Bei einer weitere Ausgestaltung des magnetisch-induktiven Durchflussmessgerätes sind wenigstens drei Sensoren an der Magnetkreisvorrichtung angeordnet, wobei ein Sensor als Temperatursensor, ein weiterer Sensor als Beschleunigungssensor und ein noch weiterer Sensor als Magnetfeldsensor oder Magnetfeldschalter ausgestaltet ist. Durch diese erfindungsgemäße Ausgestaltung des magnetisch-induktiven Durchflussmessgerätes ist es möglich, drei verschiedene auf die Magnetkreisvorrichtung wirkende physikalische Störgrößen, nämlich sowohl die Temperatur als auch die Beschleunigung als auch ein äußeres Magnetfeld, zu erfassen. Das erfindungsgemäße Durchflussmessgerät ist jedoch nicht auf die Anordnung von drei Sensoren an der Magnetkreisvorrichtung beschränkt, vielmehr kann eine beliebige Anzahl an Sensoren an der Magnetkreisvorrichtung angeordnet sein. Eine ganz besonders bevorzugte Ausführungsform des magnetisch-induktiven Durchflussmessgerätes ist demnach beispielsweise dadurch gekennzeichnet, dass fünf Sensoren an der Magnetkreisvorrichtung angeordnet sind, nämlich ein Temperatursensor, ein Beschleunigungssensor und drei Magnetfeldsensoren, wobei die jeweiligen Magnetfeldsensoren in unterschiedliche Raumrichtungen, die vorzugsweise orthogonal zueinander sind, sensitiv sind. Dadurch kann ein auf die Magnetkreisvorrichtung wirkendes äußeres Magnetfeld vollständig erfasst werden, da seine Komponenten in jede Raumrichtung erfasst werden.

Eine besonders bevorzugte Ausgestaltung des erfindungsgemäßen magnetisch-induktiven Durchflussmessgerätes ist dadurch gegeben, dass der Sensor mittels eines Sensorbefestigungselementes an der Magnetkreisvorrichtung befestigt ist. Sind mehrere Sensoren an der Magnetkreisvorrichtung angeordnet, so können die mehreren Sensoren mittels eines Sensorbefestigungselementes an der Magnetkreisvorrichtung befestigt sein. Die mehreren Sensoren können dabei insgesamt mittels eines einzigen Sensorbefestigungselements an der Magnetkreisvorrichtung befestigt sein, ebenfalls können mehrere Sensorbefestigungselemente vorgesehen sein. In einer besonders bevorzugten Ausgestaltung ist das Sensorbefestigungselement als Leiterplatte ausgebildet.

Durch die Verwendung eines Sensorbefestigungselements ergibt sich insbesondere der Vorteil, dass eine einfache Montage der Sensoren an der Magnetkreisvorrichtung möglich ist. Die Sensoren können dabei zunächst auf dem Sensorbefestigungselement montiert werden, bevor dann das Sensorbefestigungselement mit der Magnetkreisvorrichtung zusammengebracht wird. Auf die Art der Verbindung zwischen Magnetkreisvorrichtung und Sensorbefestigungselement kommt es vorliegend nicht an. Bevorzugt wird eine Leiterplatte als Sensorbefestigungselement verwendet. Vorteilhaft ist weiterhin, dass eine Mehrzahl an Sensorbefestigungselementen "auf Vorrat" mit Sensoren bestückt werden kann.

Eine weitere Ausgestaltung des erfindungsgemäßen Durchflussmessgerätes ist dadurch gekennzeichnet, dass das Sensorbefestigungselement als Winkel ausgebildet ist. Besonders bevorzugt ist das Sensorbefestigungselement als rechter Winkel ausgebildet. Diese Ausgestaltung ist insbesondere dann vorteilhaft, wenn eine Mehrzahl an Magnetfeldsensoren vorgesehen ist. Durch den Winkel wird ermöglicht, die Magnetfeldsensoren, insbesondere drei Magnetfeldsensoren, derartig anzuordnen, dass ein äußeres auf die Magnetkreisvorrichtung wirkendes Magnetfeld in allen drei Raumrichtungen erfasst werden kann.

Die Erfindung betrifft ferner ein Verfahren zum Betreiben eines magnetisch-induktiven Durchflussmessgerätes. Das magnetisch-induktive Durchflussmessgerät weist auf ein Messrohr, eine Magnetfelderzeugungseinrichtung zur Erzeugung eines das Messrohr durchsetzenden Messmagnetfeldes, eine Magnetkreisvorrichtung zur Führung des Messmagnetfeldes außerhalb des Messrohres, Elektroden zur Erfassung einer durchflussabhängigen elektrischen Messspannung bei Durchströmen des Messrohres mit einem leitfähigen Medium und eine elektronische Steuer- und Auswerteeinrichtung. An der Magnetkreisvorrichtung ist ein Sensor zur Erfassung einer auf die Magnetkreisvorrichtung wirkenden physikalischen Störgröße angeordnet, wobei das Messmagnetfeld durch die physikalische Störgröße beeinflusst wird.

Wenn es heißt, dass ein Sensor an der Magnetkreisvorrichtung angeordnet ist, dann ist das kein zahlenmäßig beschränkendes Merkmal. Vielmehr können - wie im Zusammenhang mit dem erfindungsgemäßen magnetisch-induktiven Durchflussmessgerät beschrieben - eine Mehrzahl von Sensoren an der Magnetkreisvorrichtung angeordnet sein.

Bei dem erfindungsgemäßen Verfahren wird zunächst mit dem Sensor die auf die Magnetkreisvorrichtung wirkende physikalische Störgröße erfasst.

Nach der Erfassung der physikalischen Störgröße können gemäß dem erfindungsgemäßen Verfahren zwei alternative Verfahrensabläufe durchgeführt werden:
In einem ersten Verfahrensablauf wird die physikalische Störgröße mit einem vorgegebenen Grenzwert vergleichen und bei Überschreiten oder Unterschreiten des Grenzwertes ein Fehlerzustand signalisiert. Wird ein Fehlerzustand signalisiert, dann wird die Durchflussmessung nach der Signalisierung des Fehlerzustandes abgebrochen.
In einem zweiten Verfahrensablauf wird die physikalische Störgröße nach ihrer Erfassung mit einem vorgegebenen Grenzwert verglichen. Ebenfalls wird bei einem Überschreiten oder Unterschreiten des Grenzwertes ein Fehlerzustand signalisiert. Wird ein Fehlerzustand signalisiert, dann wird die Durchflussmessung nicht abgebrochen, sondern es wird (weiterhin) eine Korrektur der Auswirkung der physikalischen Störgröße auf die Durchflussmessung durchgeführt.

Die Entscheidung, ob die Durchflussmessung nach der Signalisierung des Fehlerzustandes abgebrochen wird, oder ob eine Korrektur der Auswirkung der physikalischen Störgröße auf die Durchflussmessung durchgeführt wird, kann beispielsweise aktiv von einem Benutzer getroffen werden, sie kann aber auch fest vorgegeben sein.

In einer bevorzugten Ausführungsform des erfindungsgemäßen Verfahrens wird die physikalische Störgröße nach ihrer Erfassung mit einem vorgegebenen Grenzwert verglichen. Wird kein Fehlerzustand signalisiert, wird der Grenzwert also nicht überschritten oder unterschritten, dann wird eine Korrektur der Auswirkung der physikalischen Störgröße auf die Durchflussmessung durchgeführt.

In einem nicht erfindungsgemäßen Verfahrensablauf wird nach der Erfassung der physikalischen Störgröße direkt eine Korrektur der Auswirkung der physikalischen Störgröße auf die Durchflussmessung durchgeführt. Das Verfahren gemäß dem nicht erfindungsgemäßen Verfahrensablauf unterscheidet sich also von dem Verfahren gemäß der oben beschriebenen bevorzugten Ausführungsform des erfindungsgemäßen Verfahrens dadurch, dass ein Vergleich mit einem Grenzwert nicht durchgeführt wird. Dies ist beispielsweise dann der Fall, wenn in der Steuer- und Auswerteeinrichtung kein Grenzwert abgelegt ist.

Das erfindungsgemäße Verfahren ist nicht darauf begrenzt, dass nur ein Grenzwert vorgegeben werden kann. Vielmehr können beispielsweise ein oberer Grenzwert und ein unterer Grenzwert für die physikalische Störgröße vorgegeben werden. Ein Fehlerzustand wird dann sowohl bei Überschreiten des oberen Grenzwertes als auch bei Unterschreiten des unteren Grenzwertes signalisiert.

Um eine Korrektur der Auswirkung der physikalischen Störgröße auf die Durchflussmessung durchführen zu können, ist in einer Ausführungsform des erfindungsgemäßen Verfahrens vorgesehen, dass in der Steuer- und Auswerteeinrichtung Korrekturdaten zur Korrektur der magnetisch-induktiven Durchflussmessung abgelegt werden. Diese Korrekturdaten können dann von der Steuer- und Auswerteeinrichtung abgerufen und verwendet werden.

Ist der Sensor als Temperatursensor ausgebildet, dann beschreiben die Korrekturdaten die Abhängigkeit der Messspannung von der Temperatur der Magnetkreisvorrichtung. Die Abhängigkeit der Messspannung von der Temperatur der Magnetkreisvorrichtung ist verursacht durch die Abhängigkeit des Messmagnetfeldes von der Temperatur der Magnetkreisvorrichtung.

Ist der Sensor als Magnetfeldsensor ausgebildet, dann beschreiben die Korrekturdaten die Abhängigkeit der Messspannung von dem äußeren auf die Magnetkreisvorrichtung wirkenden Magnetfeld. Die Abhängigkeit der Messspannung von dem äußeren auf die Magnetkreisvorrichtung wirkenden Magnetfeld wird verursacht durch die Abhängigkeit des Messmagnetfeldes von dem äußeren auf die Magnetkreisvorrichtung wirkenden Magnetfeld. Ist der Sensor sensitiv für eine Raumkomponente des äußeren Magnetfeldes, dann bezieht sich die Abhängigkeit auf diese Raumrichtung.

Die Erfassung der jeweiligen Korrekturdaten kann beispielsweise durch Aufnahme eines Kennlinienfeldes erfolgen. Hierfür kann das magnetisch-induktive Durchflussmessgerät mit verschiedenen konstanten und bekannten Durchflüssen betrieben werden, wobei für jeden Durchfluss die Temperatur der Magnetkreisvorrichtung erhöht oder das äußere auf die Magnetkreisvorrichtung wirkende Magnetfeld verändert wird und die Messspannung gemessen wird. Die Korrekturdaten können im Rahmen einer Typprüfung aufgenommen werden und müssen nicht für jedes typgleiche Durchflussmessgerät einzeln aufgenommen werden. Zwischen den Stützstellen der Korrekturkennlinie oder des Korrekturkennlinienfeldes können Korrekturdaten interpoliert werden. Die Verläufe der Kennlinien oder Kennlinienfelder zur Korrektur können auch durch stetige Kurvenverläufe mathematisch modelliert werden (Polynome, Splines usw.).

Die Korrektur der Auswirkungen der physikalischen Störgröße auf die Durchflussmessung erfolgt auf unterschiedliche Art und Weise - je nach Art der Störgröße. Ist die Störgröße die Temperatur der Magnetkreisvorrichtung oder ist die Störgröße ein auf die Magnetkreisvorrichtung wirkendes äußeres Magnetfeld, ist also der Sensor als Temperatursensor oder als Magnetfeldsensor ausgebildet, dann wird die Korrektur der Auswirkung der physikalischen Störgröße dadurch realisiert, dass die erfasste elektrische Messspannung bei Durchströmen des Messrohres mit einem leitfähigen Medium mit den Korrekturdaten korrigiert wird.

Ist der Sensor als Beschleunigungssensor ausgebildet, erfasst der Sensor also die Beschleunigung der Magnetkreisvorrichtung, wobei die Beschleunigung insbesondere durch Vibrationen der Magnetkreisvorrichtung bedingt ist, dann wird die Korrektur der Auswirkung der physikalischen Störgröße auf die Durchflussmessung beispielsweise dadurch realisiert, dass die Messfrequenz zur Erfassung der elektrischen Messspannung derart gewählt wird, dass die Abtastperiodendauer einem Vielfachen der Vibrationsperiodendauer entspricht. Die Vibrationen der Magnetkreisvorrichtung weisen eine Vibrationsfrequenz und eine Vibrationsamplitude auf, die von dem Beschleunigungssensor erfasst werden. Die Vibrationsperiodendauer ergibt sich aus dem Kehrwert der Vibrationsfrequenz. Dadurch, dass die Abtastperiodendauer, also die Periodendauer, mit der die Messwerte aufgenommen werden, einem Vielfachen der Vibrationsperiodendauer entspricht - die Abtastperiodendauer kann hierbei auch der Vibrationsperiodendauer entsprechen, also das "Einfache" der Vibrationsperiodendauer sein - werden durch die Abtastung bedingte Schwebungseffekte unterdrückt.

Das Messsignal selbst kann auch eine periodische Messsignalschwingung aufweisen. Diese periodische Messsignalschwingung kann daher rühren, dass der Durchfluss selbst eine Schwingung aufweist. Ist die Beschleunigung der Magnetkreisvorrichtung eine periodische Vibration mit einer Vibrationsamplitude und mit einer Vibrationsfrequenz und weist das Messsignal eine periodische Messsignalschwingung auf, dann ist eine Ausführungsform des erfindungsgemäßen Verfahrens dadurch realisiert, dass die Messsignalfrequenz der periodischen Messsignalschwingung bestimmt wird und die Messsignalfrequenz mit der Vibrationsfrequenz verglichen wird. Eine Korrektur der Auswirkung der physikalischen Störgröße auf die Durchflussmessung wird dann durchgeführt, wenn die Messsignalfrequenz mit der Vibrationsfrequenz der Magnetkreisvorrichtung übereinstimmt oder wenn die Vibrationsfrequenz in der Messsignalschwingung enthalten ist.

Wenn die Messsignalfrequenz mit der Vibrationsfrequenz übereinstimmt, dann ist eine sehr hohe Wahrscheinlichkeit gegeben, dass die Durchflussmessung durch die Vibration beeinflusst ist. Gleiches gilt, wenn in dem Messsignal der Durchflussmessung ein Anteil mit Vibrationsfrequenz zu finden ist. Das Medium weist dann selbst eine Durchflussschwingung auf, der Durchfluss ist aber zudem durch die Vibrationen gestört. Weist das Messsignal keinen Anteil mit der Vibrationsfrequenz der Magnetkreisvorrichtung auf, sondern lediglich eine Durchflussschwingung mit einer anderen Frequenz, dann ist die Durchflussmessung durch die Vibrationen nicht gestört oder beeinflusst. Der Durchfluss selbst weist eine Schwingung auf, muss aber nicht korrigiert werden.

Die im Zusammenhang mit dem magnetisch-induktiven Durchflussmessgerät gemachten Ausführungen sind ebenfalls auf das Verfahren übertragbar und umgekehrt.

Im Einzelnen gibt es nun verschiedene Möglichkeiten, das erfindungsgemäße magnetisch-induktive Durchflussmessgerät und das erfindungsgemäße Verfahren zum Betreiben eines magnetisch-induktiven Durchflussmessgerätes auszugestalten und weiterzubilden. Dazu wird verwiesen sowohl auf die den unabhängigen Patentansprüchen nachgeordneten Patentansprüche als auch auf die Beschreibung bevorzugter Ausgestaltungen und Ausführungsbeispiele in Verbindung mit der Zeichnung. In der Zeichnung zeigen
- Fig. 1: ein magnetisch-induktives Durchflussmessgerät gemäß einer ersten Ausgestaltung,
- Fig. 2: einen Querschnitt des in Fig. 1 gezeigten magnetisch-induktiven Durchflussmessgerätes,
- Fig. 3: ein magnetisch-induktives Durchflussmessgerät gemäß einer zweiten Ausgestaltung,
- Fig. 4: einen Querschnitt eines magnetisch-induktiven Durchflussmessgerätes gemäß einer dritten Ausgestaltung,
- Fig. 5: einen Querschnitt eines magnetisch-induktiven Durchflussmessgerätes gemäß einer vierten Ausgestaltung,
- Fig. 6: ein Blockdiagramm beschreibend ein erstes Verfahren zum Betreiben eines magnetisch-induktiven Durchflussmessgerätes,
- Fig. 7: ein Blockdiagramm beschreibend ein zweites Verfahren zum Betreiben eines magnetisch-induktiven Durchflussmessgerätes und
- Fig. 8: ein Blockdiagramm beschreibend ein drittes Verfahren zum Betreiben eines magnetisch-induktiven Durchflussmessgerätes.

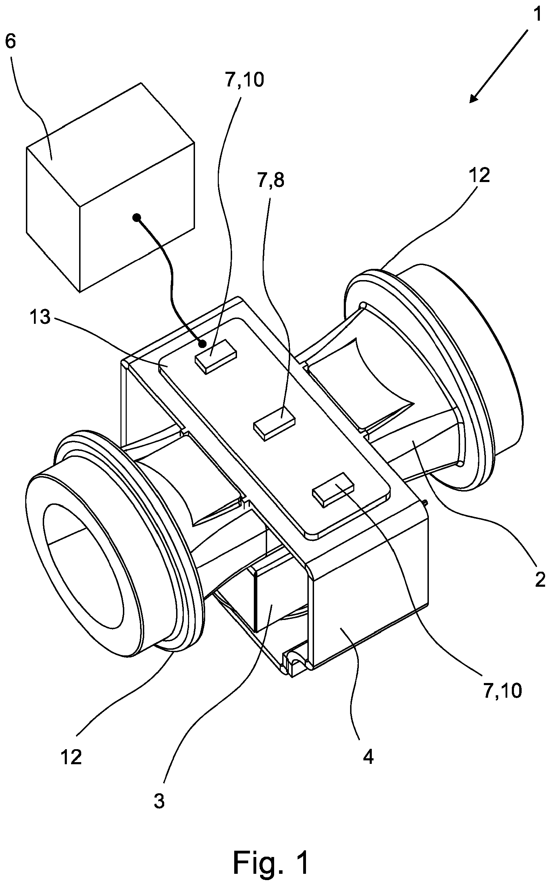

In Fig. 1 dargestellt ist ein magnetisch-induktives Durchflussmessgerät 1. Das magnetisch-induktive Durchflussmessgerät 1 dient zur Messung des Durchflusses eines leitfähigen Mediums, das durch ein Messrohr 2 strömt. Eine Magnetfelderzeugungseinrichtung 3 erzeugt ein Messmagnetfeld, das das Messrohr 2 durchsetzt. Das Messmagnetfeld wird mittels einer Magnetkreisvorrichtung 4 außerhalb des Messrohres 2 geführt und auf den Bereich des Messrohres 2 konzentriert.

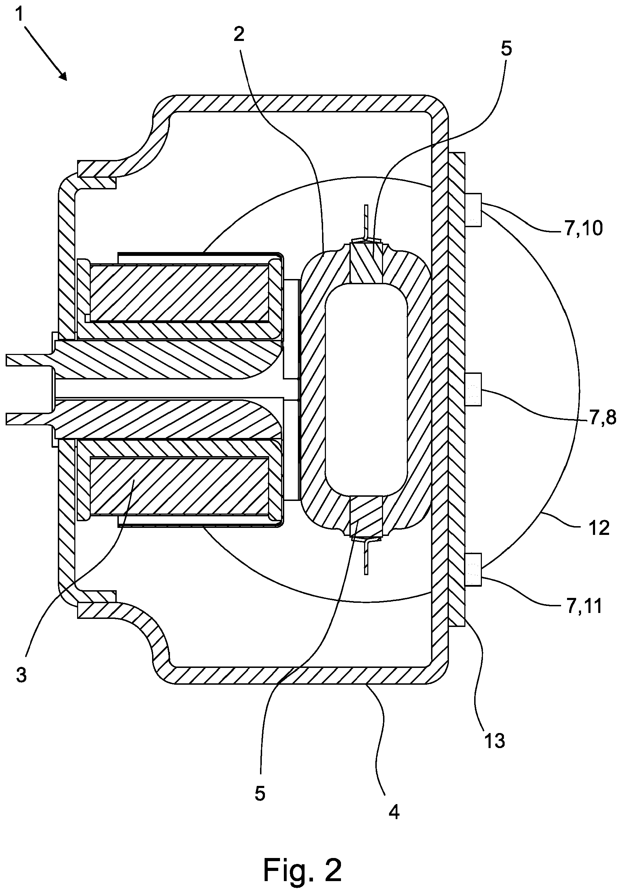

Das Messmagnetfeld bewirkt eine Ladungstrennung in dem leitfähigen, durch das Messrohr 2 strömenden Medium. Die Ladungstrennung im Medium führt wiederum dazu, dass eine Messspannung im Medium induziert wird, die mit Hilfe der - in Fig. 2 dargestellten - Elektroden 5 abgegriffen wird. Die Messspannung ist proportional zu der Geschwindigkeit, mit der das Medium durch das Messrohr 2 strömt. Mit Hilfe der Geschwindigkeit und dem Durchmesser des Messrohres 2 lässt sich dann der Durchfluss des Mediums bestimmen.

Eine elektronische Steuer- und Auswerteeinrichtung 6 dient zur Steuerung des magnetisch-induktiven Durchflussmessgerätes und zur Auswertung der Durchflussmessung. Die Messspannung ist nicht nur proportional zu der Durchflussgeschwindigkeit des Mediums, sondern ist zudem proportional zu dem Messmagnetfeld. Demnach ist es wichtig, dass mit hoher Wiederholgenauigkeit ein Messmagnetfeld in dem Messrohr 2 erzeugt wird, um den Durchfluss dauerhaft exakt bestimmen zu können.

Das Messmagnetfeld kann jedoch beeinflusst werden. Insbesondere indirekte Einflüsse auf das Messmagnetfeld sind nicht zu vernachlässigen. Diese indirekten Einflüsse sind solche Einflüsse, die die Eigenschaften der Magnetkreisvorrichtung 4 beeinflussen. Verändern sich die Eigenschaften der Magnetkreisvorrichtung 4, dann resultiert das in einem veränderten Messmagnetfeld, wodurch die Durchflussmessung gestört und verfälscht wird. Ein solcher Einfluss ist beispielsweise die Temperatur der Magnetkreisvorrichtung 4. Die Magnetkreisvorrichtung 4 ist aus einem - bevorzugt weichmagnetischen - Material mit einer bestimmten Permeabilität gefertigt. Die Permeabilität ist eine temperaturabhängige Größe, ändert sich also mit der Temperatur. Eine veränderte Permeabilität resultiert dann in einem veränderten Messmagnetfeld.

Ein weiterer Einfluss ist in einem äußeren auf die Magnetkreisvorrichtung 4 wirkenden Magnetfeld zu sehen. Durch das äußere Magnetfeld kann es zu einer Sättigung der Magnetkreisvorrichtung 4, zumindest jedoch zu einer Ausrichtung der magnetischen Momente in der Magnetkreisvorrichtung 4 in Richtung des äußeren Magnetfeldes kommen, wodurch die Magnetfeldführung und damit das Messmagnetfeld ebenfalls beeinflusst werden.

Ebenfalls einen Einfluss haben Beschleunigungen der Magnetkreisvorrichtung 4. Solche Beschleunigungen sind insbesondere durch Vibrationen der Magnetkreisvorrichtung 4 bedingt, die beispielsweise von einer mit dem magnetisch-induktiven Durchflussmessgerät 1 verbundenen Pumpe oder einer anderen Komponente des magnetisch-induktiven Durchflussmessgerätes 1 herrühren können. Diese physikalischen Störgrößen - insbesondere die Temperatur der Magnetkreisvorrichtung 4, ein äußeres auf die Magnetkreisvorrichtung 4 wirkendes Magnetfeld und eine Beschleunigung der Magnetkreisvorrichtung 4 - beeinflussen also das Messmagnetfeld.

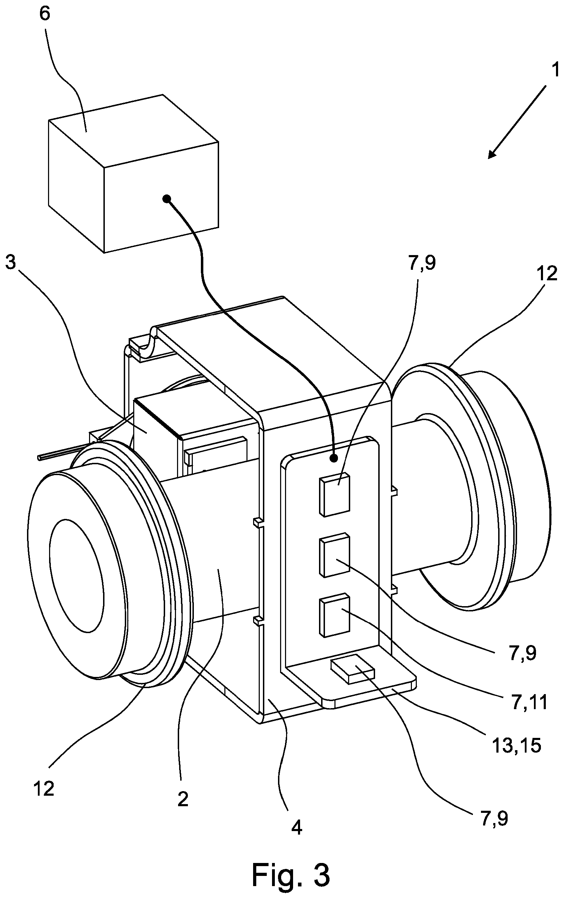

Um die physikalischen Störgrößen zu erfassen, sind an der Magnetkreisvorrichtung 4 Sensoren 7 angeordnet. Die Sensoren 7 sind auf der dem Messrohr 2 abgewandten Seite der Magnetkreisvorrichtung 4 angeordnet. An der in Fig. 1 dargestellten Magnetkreisvorrichtung 4 sind drei Sensoren 7 angeordnet. Ein erster Sensor 7 ist als Temperatursensor 8 ausgestaltet und dient zur Erfassung der Temperatur der Magnetkreisvorrichtung 4. Zur Erfassung des äußeren auf die Magnetkreisvorrichtung 4 wirkenden Magnetfeldes können Magnetfeldsensoren 9 - dargestellt beispielsweise in Fig. 3 - oder Magnetfeldschalter 10 verwendet werden. Die beiden anderen in Fig. 1 dargestellten Sensoren sind als Magnetfeldschalter 10 ausgebildet. Die beiden Magnetfeldschalter 10 sind sensitiv für jeweils eine andere Komponente - eine Komponente des äußeren Magnetfeldes entlang einer anderen Raumrichtung. Mit den beiden Magnetfeldsensoren 10 lassen sich also insgesamt zwei Komponenten des äußeren Magnetfeldes, also die Komponenten des äußeren Magnetfeldes entlang zweier unterschiedlicher Raumrichtungen erfassen.

In Fig. 2 dargestellt ist ein Querschnitt eines im Wesentlichen dem in Fig. 1 dargestellten magnetisch-induktiven Durchflussmessgerätes 1 entsprechenden magnetisch-induktiven Durchflussmessgerätes 1. Das in Fig. 2 dargestellte Durchflussmessgerät 1 unterscheidet sich von dem in Fig. 1 dargestellten lediglich durch die Art der Sensoren 7, die an der Magnetkreisvorrichtung 4 angeordnet sind. Die Sensoren 7 sind nämlich einmal als Temperatursensor 8, einmal als Magnetfeldschalter 10 und einmal als Beschleunigungssensor 11 ausgestaltet. Der Beschleunigungssensor 11 dient zur Erfassung einer Vibration der Magnetkreisvorrichtung 4, wobei die Vibrationsfrequenz und die Vibrationsamplitude erfasst werden. Das Messrohr 2 ist im Bereich der Elektroden 5 abgeflacht und weist einen im Wesentlichen rechteckigen Querschnitt auf, wobei die Elektroden 5 an der schmalen Seite angeordnet sind. An seinen beiden Enden weist das Messrohr 2 jeweils einen Flansch 12 auf, mit dem das Messrohr 2 in eine Messstrecke eingebaut werden kann.

Sowohl in Fig. 1 als auch in Fig. 2 sind die Sensoren 7 mittels eines Sensorbefestigungselementes 13, nämlich einer Leiterplatte 14, an der Magnetkreisvorrichtung 4 befestigt. Die Steuer- und Auswerteeinrichtung 6 ist über nicht dargestellte Leiterbahnen der Leiterplatte 14 mit den Sensoren 7 verbunden . Die Steuer- und Auswerteeinrichtung 6 ist derart ausgestaltet, dass sie ein Überschreiten oder ein Unterschreiten eines vorgebbaren Grenzwertes der physikalischen Störgröße - der Temperatur und/oder des äußeren Magnetfeldes und/oder der Vibration - erkennt und signalisiert und/oder eine Korrektur der Auswirkung der physikalischen Störgröße auf die Durchflussmessung durchführt.

Fig. 3 zeigt eine weitere Ausgestaltung des magnetisch-induktiven Durchflussmessgerätes 1. Das Durchflussmessgerät 1 weist ein Messrohr 2 mit einem runden Querschnitt auf. Anders als in den Fig. 1 und 2 ist das Sensorbefestigungselement 13 als Winkel 15 ausgebildet. Auf dem Winkel 15 sind vier Sensoren 7 angeordnet. Durch die Ausgestaltung des Sensorbefestigungselementes 13 als Winkel 15 wird ermöglicht, drei Magnetfeldsensoren 9 derart anzuordnen, dass alle drei Komponenten eines äußeren Magnetfeldes erfasst werden können, nämlich die Komponenten entlang jeder der drei Raumrichtungen. Die drei Magnetfeldsensoren 9 sind demnach sensitiv auf jeweils eine Komponente des äußeren Magnetfeldes. Zudem ist auf dem Winkel 15 ein Beschleunigungssensor 11 angeordnet.

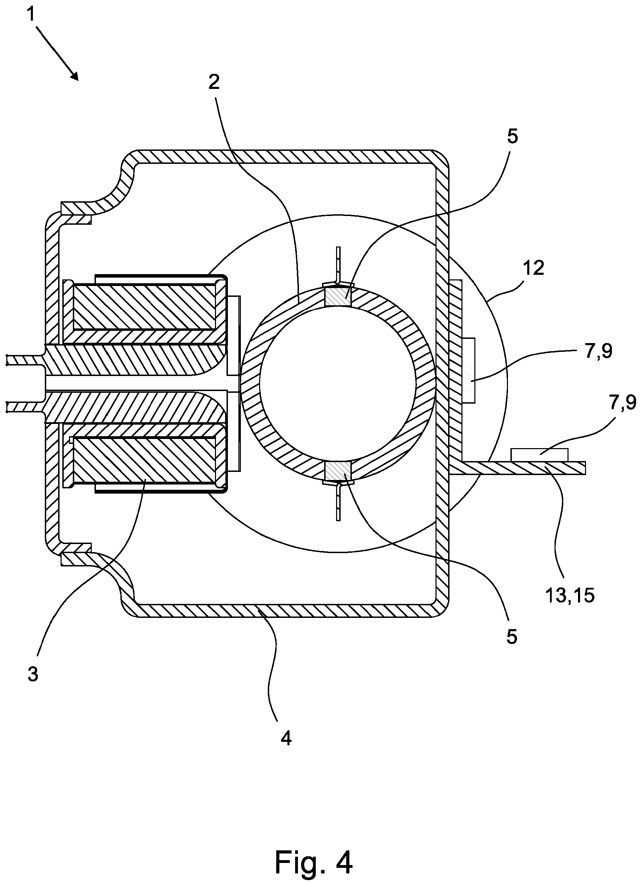

In Fig. 4 dargestellt ist wiederum ein Querschnitt eines magnetisch-induktiven Durchflussmessgerätes 1. Das Messrohr 2 weist ebenso wie in Fig. 3 einen runden Querschnitt auf. Das Sensorbefestigungselement 13 ist ebenfalls als Winkel 15 ausgebildet. Insgesamt weist das Durchflussmessgerät 1 zwei Sensoren 7 auf, nämlich zwei Magnetfeldsensoren 9.

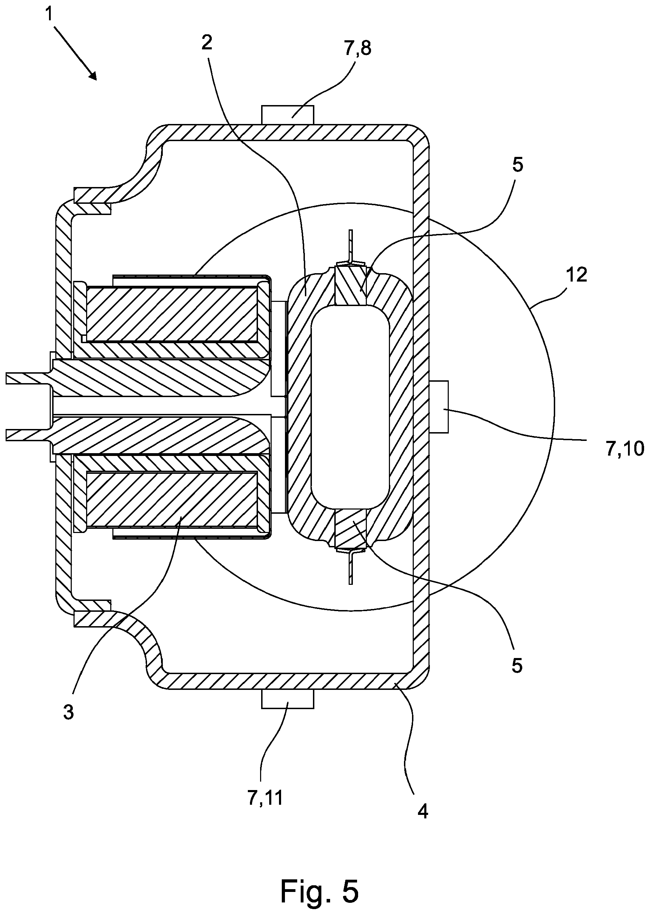

Fig. 5 zeigt eine weitere Ausgestaltung eines magnetisch-induktiven Durchflussmessgerätes 1. Im Gegensatz zu den bisher dargestellten Ausgestaltungen sind bei dem in Fig. 5 gezeigten Durchflussmessgerät 1 die Sensoren 7 direkt an der Magnetkreisvorrichtung befestigt, also nicht mittels eines Sensorbefestigungselementes 13 befestigt.

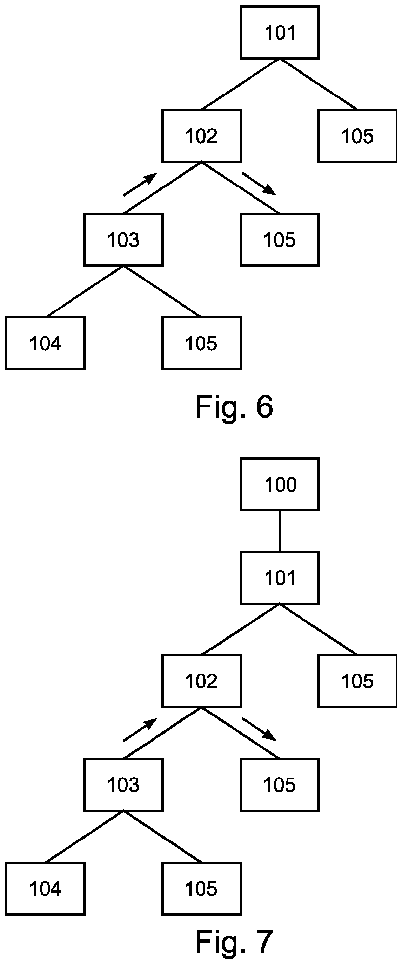

In Fig. 6 dargestellt ist ein Blockdiagramm eines Verfahrens zum Betreiben eines beschriebenen magnetisch-induktiven Durchflussmessgerätes 1. In einem ersten Schritt 101 wird zunächst die physikalische Störgröße, die auf Magnetkreisvorrichtung 4 wirkt, mit dem Sensor 7 erfasst. Nach der Erfassung der physikalischen Störgröße können verschiedene Verfahrensabläufe durchgeführt, die alle in Fig. 6 dargestellt sind:
Nachdem die physikalische Störgröße erfasst ist 101, wird sie in einem Verfahrensablauf mit einem in der Steuer- und Auswerteeinrichtung 6 abgelegten Grenzwert verglichen 102. Der Grenzwert kann hierbei ein oberer Grenzwert oder ein unterer Grenzwert sein. Ebenfalls können sowohl ein oberer als auch ein unterer Grenzwert abgelegt sein. Überschreitet die erfasste physikalische Störgröße den oberen Grenzwert oder unterschreitet sie den unteren Grenzwert - dargestellt durch den nach oben zeigenden Pfeil in Fig. 6 - wird ein Fehlerzustand signalisiert 103. Ist der Fehlerzustand signalisiert 103, wird die Durchflussmessung entweder abgebrochen 104 oder es erfolgt eine Korrektur der Auswirkung der physikalischen Störgröße auf die Durchflussmessung 105.

Wird nach dem Vergleich der physikalischen Störgröße mit dem vorgegebenen Grenzwert 102 kein Fehlerzustand signalisiert, überschreitet die physikalische Störgröße also keinen oberen Grenzwert oder unterschreitet sie keinen unteren Grenzwert, was durch den nach unten zeigenden Pfeil in der Fig. 6 dargestellt ist, dann erfolgt eine Korrektur der Auswirkung der physikalischen Störgröße auf die Durchflussmessung 105.

Ein anderer Verfahrensablauf sieht vor, dass direkt nach der Erfassung der physikalischen Störgröße 101 eine Korrektur der Auswirkung der physikalischen Störgröße auf die Durchflussmessung 105 erfolgt. Es ist also kein Vergleich mit einem Grenzwert 102 vorgesehen.

Fig. 7 zeigt ein Blockdiagramm eines Verfahrens zum Betreiben eines magnetisch-induktiven Durchflussmessgerätes 1 der beschriebenen Art, das im Wesentlichen dem in Fig. 1 beschriebenen Verfahren entspricht, wobei jedoch ein weiterer Verfahrens schritt 100 vorgeschaltet ist. Um eine Korrektur der Auswirkungen der physikalischen Störgröße auf die Durchflussmessung durchführen zu können, werden in einem Verfahrensschritt 100 Korrekturdaten zur Korrektur der magnetisch-induktiven Durchflussmessung in der Steuer- und Auswerteeinrichtung 6 abgelegt. Diese Korrekturdaten beschreiben dabei die Abhängigkeit der Messspannung von der auf die Magnetkreisvorrichtung 4 wirkenden physikalischen Größe. Ist die physikalische Störgröße also die Temperatur der Magnetkreisvorrichtung 4, ist der Sensor 7 also als Temperatursensor 9 ausgestaltet, dann beschreiben die Korrekturdaten die Abhängigkeit der Messspannung von der Temperatur der Magnetkreisrichtung 4. Ist hingegen die physikalische Störgröße ein äußeres auf die Magnetkreisvorrichtung 4 wirkendes Magnetfeld und erfasst der Sensor 7, der als Magnetfeldsensor 9, oder als Magnetfeldschalter 10 ausgestaltet ist, das äußere Magnetfeld, dann beschreiben die Korrekturdaten die Abhängigkeit der Messspannung von dem äußeren auf die Magnetkreisvorrichtung 4 wirkenden Magnetfeld. Die Korrektur der Auswirkungen der physikalischen Störgröße wird dadurch realisiert, dass die erfasste elektrische Messspannung bei Durchströmen des Messrohres mit dem leitfähigen Medium mit den Korrekturdaten, die in der Steuer- und Auswerteeinrichtung 6 abgelegt sind, korrigiert wird.

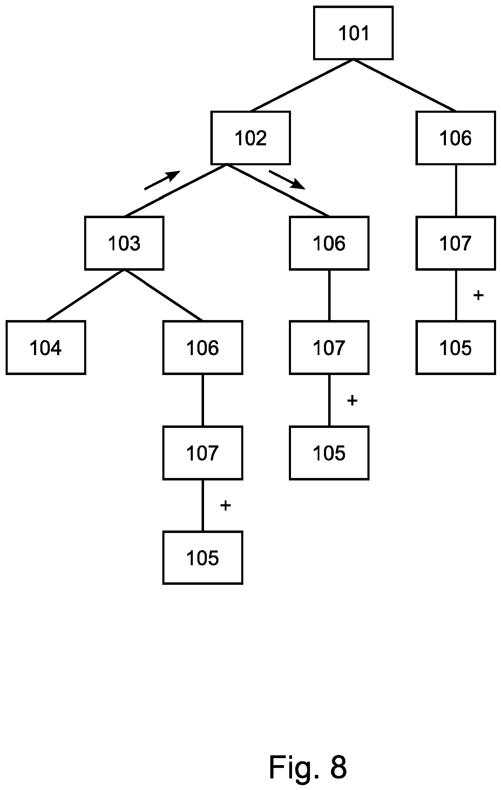

In Fig. 8 dargestellt ist ein weiteres Blockdiagramm eines Verfahrens zum Betreiben des magnetisch-induktiven Durchflussmessgerätes 1. Das Verfahren nach Fig. 8 wird dann durchgeführt, wenn die physikalische Störgröße eine Beschleunigung der Magnetkreisvorrichtung 4 ist, wobei die Beschleunigung eine periodische Vibration mit einer Vibrationsamplitude und einer Vibrationsfrequenz ist und wobei das Messsignal eine periodische Messsignalschwingung aufweist. Bevor eine Korrektur der Auswirkung der physikalischen Störgröße auf die Durchflussmessung durchgeführt wird 105, wird in einem vorgeschalteten Verfahrensschritt 106 die Messsignalfrequenz der periodischen Messsignalschwingung bestimmt. In dem Verfahrensschritt 107 wird dann die Messsignalfrequenz mit der Vibrationsfrequenz der periodischen Vibration der Magnetkreisvorrichtung 4 verglichen. Eine Korrektur 105 der Auswirkungen der periodischen Vibration auf die Durchflussmessung wird dann durchgeführt, wenn die Messsignalfrequenz mit der Vibrationsfrequenz der Magnetkreisvorrichtung übereinstimmt oder wenn die Vibrationsfrequenz in der Messsignalschwingung enthalten ist - verdeutlicht durch das Pluszeichen in der Fig. 8.

### Bezugszeichen

- 1: magnetisch-induktives Durchflussmessgerät
- 2: Messrohr
- 3: Magnetfelderzeugungseinrichtung
- 4: Magnetkreisvorrichtung
- 5: Elektrode
- 6: Steuer- und Auswerteeinrichtung
- 7: Sensor
- 8: Temperatursensor
- 9: Magnetfeldsensor
- 10: Magnetfeldschalter
- 11: Beschleunigungssensor
- 12: Flansch
- 13: Sensorbefestigungselement
- 14: Leiterplatte
- 15: Winkel

- 100: Ablegung von Korrekturdaten in der Steuer- und Auswerteeinrichtung
- 101: Erfassung der auf die Magnetkreisvorrichtung wirkenden physikalischen Störgröße
- 102: Vergleich der physikalischen Störgröße mit einem vorgegebenen Grenzwert
- 103: Signalisierung eines Fehlerzustandes bei Überschreiten oder Unterschreiten des Grenzwertes
- 104: Abbruch der Durchflussmessung
- 105: Korrektur der Auswirkungen der physikalischen Störgröße auf die Durchflussmessung
- 106: Bestimmung der Messsignalfrequenz einer periodischen Messsignalschwingung
- 107: Vergleich der Messsignalfrequenz mit der Vibrationsfrequenz

## Patentansprüche

1. Magnetisch-induktives Durchflussmessgerät (1) zur Messung des Durchflusses eines leitfähigen Mediums, mit einem Messrohr (2), mit einer Magnetfelderzeugungseinrichtung (3) zur Erzeugung eines das Messrohr (2) durchsetzenden Messmagnetfeldes, mit einer Magnetkreisvorrichtung (4) zur Führung des Messmagnetfeldes außerhalb des Messrohres (2), mit Elektroden (5) zur Erfassung einer durchflussabhängigen elektrischen Messspannung bei Durchströmen des Messrohres (2) mit dem leitfähigen Medium und mit einer elektronischen Steuer- und Auswerteeinrichtung (6),
**dadurch gekennzeichnet,**
**dass** an der Magnetkreisvorrichtung (4) ein Sensor (7) zur Erfassung einer auf die Magnetkreisvorrichtung (4) wirkenden physikalischen Störgröße angeordnet ist, wobei das Messmagnetfeld durch die physikalische Störgröße beeinflusst wird und wobei die Steuer- und Auswerteeinheit (6) derart ausgestaltet ist, dass sie ein Überschreiten oder Unterschreiten eines vorgebbaren Grenzwertes der physikalischen Störgröße erkennt und signalisiert.

2. Magnetisch-induktives Durchflussmessgerät (1) nach Anspruch 1, **dadurch gekennzeichnet, dass** die Steuer- und Auswerteeinheit (6) derart ausgestaltet ist, dass sie eine Korrektur der Auswirkung der physikalischen Störgröße auf die Durchflussmessung durchführt.

3. Magnetisch-induktives Durchflussmessgerät (1) nach Anspruch 1 oder 2, **dadurch gekennzeichnet, dass** der Sensor (7) als Temperatursensor (8) ausgestaltet ist und zur Erfassung der Temperatur der Magnetkreisvorrichtung (4) dient.

4. Magnetisch-induktives Durchflussmessgerät (1) nach Anspruch 1 oder 2, **dadurch gekennzeichnet, dass** der Sensor (7) als Magnetfeldsensor (9) - insbesondere als Hall-Sensor - ausgestaltet ist und zur Erfassung eines äußeren, auf die Magnetkreisvorrichtung (4) wirkenden Magnetfeldes dient.

5. Magnetisch-induktives Durchflussmessgerät (1) nach Anspruch 1 oder 2, **dadurch gekennzeichnet, dass** der Sensor (7) als Magnetfeldschalter (10) ausgebildet ist und zur Erfassung eines äußeren, auf die Magnetkreisvorrichtung (4) wirkenden Magnetfeldes dient.

6. Magnetisch-induktives Durchflussmessgerät (1) nach Anspruch 1 oder 2, **dadurch gekennzeichnet, dass** der Sensor (7) als Beschleunigungssensor (11) ausgestaltet ist und zur Erfassung einer - insbesondere durch Vibrationen hervorgerufenen - Beschleunigung der Magnetkreisvorrichtung (4) dient.

7. Magnetisch-induktives Durchflussmessgerät (1) nach einem der Ansprüche 1 bis 6, **dadurch gekennzeichnet, dass** wenigstens ein weiterer Sensor (7) an der Magnetkreisvorrichtung (4) angeordnet ist, insbesondere wobei der weitere Sensor (7) als Temperatursensor (8), als Magnetfeldsensor (9), als Magnetfeldschalter (10) oder als Beschleunigungssensor (11) ausgestaltet ist.

8. Magnetisch-induktives Durchflussmessgerät (1) nach Anspruch 7, **dadurch gekennzeichnet, dass** wenigstens drei Sensoren (7) an der Magnetkreisvorrichtung (4) angeordnet sind, wobei ein Sensor (7) als Temperatursensor (8), ein weiterer Sensor (7) als Beschleunigungssensor (11) und ein weiterer Sensor (7) als Magnetfeldsensor (9) oder Magnetfeldschalter (10) ausgestaltet ist.

9. Magnetisch-induktives Durchflussmessgerät (1) nach einem der Ansprüche 1 bis 8, **dadurch gekennzeichnet, dass** der Sensor (7) oder die Sensoren (7) mittels eines Sensorbefestigungselementes (13) an der Magnetkreisvorrichtung (4) befestigt ist oder sind, insbesondere, dass das Sensorbefestigungselement (13) als Leiterplatte (14) ausgebildet ist.

10. Magnetisch-induktives Durchflussmessgerät (1) nach Anspruch 9, **dadurch gekennzeichnet, dass** das Sensorbefestigungselement (13) als Winkel (15) - insbesondere als rechter Winkel - ausgebildet ist.

11. Verfahren zum Betreiben eines magnetisch-induktiven Durchflussmessgerätes (1), mit einem Messrohr (2), mit einer Magnetfelderzeugungseinrichtung (3) zur Erzeugung eines das Messrohr (2) durchsetzenden Messmagnetfeldes, mit einer Magnetkreisvorrichtung (4) zur Führung des Messmagnetfeldes außerhalb des Messrohres (2), mit Elektroden (5) zur Erfassung einer durchflussabhängigen elektrischen Messspannung bei Durchströmen des Messrohres (2) mit einem leitfähigen Medium und mit einer elektronischen Steuer- und Auswerteeinrichtung (6), wobei an der Magnetkreisvorrichtung (4) ein Sensor (7) zur Erfassung einer auf die Magnetkreisvorrichtung (4) wirkenden physikalischen Störgröße angeordnet ist, wobei das Messmagnetfeld durch die physikalische Störgröße beeinflusst wird,
wobei mit dem Sensor die auf die Magnetkreisvorrichtung wirkende physikalische Störgröße erfasst wird (101),
wobei die physikalische Störgröße mit einem vorgegebenen Grenzwert verglichen wird (102) und wobei bei Überschreiten oder Unterschreiten des Grenzwertes ein Fehlerzustand signalisiert wird (103).

12. Verfahren nach Anspruch 11, **dadurch gekennzeichnet, dass** in einem weiteren Verfahrensschritt eine Korrektur der Auswirkung der physikalischen Störgröße auf die Durchflussmessung durchgeführt wird (105).

13. Verfahren nach Anspruch 11 oder 12, **dadurch gekennzeichnet**, in der Steuer- und Auswerteeinheit Korrekturdaten zur Korrektur der magnetisch-induktiven Durchflussmessung abgelegt werden (100),
wobei, wenn der Sensor als Temperatursensor ausgebildet ist, die Korrekturdaten die Abhängigkeit der Messspannung von der Temperatur der Magnetkreisvorrichtung, verursacht durch die Temperaturabhängigkeit des Messmagnetfeldes, beschreiben und
wobei, wenn der Sensor als Magnetfeldsensor ausgebildet ist, die Korrekturdaten die Abhängigkeit der Messspannung von dem äußeren auf die Magnetkreisvorrichtung wirkenden Magnetfeld, verursacht durch die Abhängigkeit des Messmagnetfeldes von dem äußeren auf die Magnetkreisvorrichtung wirkenden Magnetfeld, beschreiben.

14. Verfahren nach Anspruch 13, wobei der Sensor als Temperatursensor ausgebildet ist und wobei der Temperatursensor die Temperatur der Magnetkreisvorrichtung erfasst, oder wobei der Sensor als Magnetfeldsensor ausgebildet ist und wobei der Magnetfeldsensor das äußere Magnetfeld an der Magnetkreisvorrichtung erfasst, **dadurch gekennzeichnet, dass** die Korrektur der Auswirkung der physikalischen Störgröße dadurch realisiert wird, dass die erfasste elektrische Messspannung bei Durchströmen des Messrohres mit einem leitfähigen Medium mit den Korrekturdaten korrigiert wird.

15. Verfahren nach Anspruch 11 oder 12, wobei der Sensor als Beschleunigungssensor ausgebildet ist und wobei der Beschleunigungssensor die Beschleunigung der Magnetkreisvorrichtung erfasst, wobei die Beschleunigung insbesondere durch Vibrationen der Magnetkreisvorrichtung bedingt ist, **dadurch gekennzeichnet, dass** die Korrektur der Auswirkung der physikalischen Störgröße auf die Durchflussmessung dadurch realisiert wird, dass die Messfrequenz zur Erfassung der elektrischen Messspannung derart gewählt wird, dass die Abtastperiodendauer einem Vielfachen der Vibrationsperiodendauer entspricht.

16. Verfahren nach Anspruch 15, wobei die Beschleunigung der Magnetkreisvorrichtung eine periodische Vibration mit einer Vibrationsamplitude und einer Vibrationsfrequenz ist und wobei das Messsignal eine periodische Messsignalschwingung aufweist, **dadurch gekennzeichnet, dass** die Messsignalfrequenz der periodischen Messsignalschwingung bestimmt wird (106), dass die Messsignalfrequenz mit der Vibrationsfrequenz verglichen wird (107) und dass eine Korrektur der Auswirkung der physikalischen Störgröße auf die Durchflussmessung durchgeführt wird (105), wenn die Messsignalfrequenz mit der Vibrationsfrequenz der Magnetkreisvorrichtung übereinstimmt oder wenn die Vibrationsfrequenz in der Messsignalschwingung enthalten ist.

## Claims

1. Magnetic-inductive flowmeter (1) for measuring the flow of a conductive medium, with a measuring tube (2), with a magnetic field generator (3) for generating a measuring magnetic field passing through the measuring tube (2), with a magnetic circuit device (4) for guiding the measuring magnetic field outside the measuring tube (2), with electrodes (5) for detecting a flow-dependent electrical measuring voltage when the conductive medium flows through the measuring tube (2), and with an electronic control and evaluation unit (6),
**characterized in**
**that** a sensor (7) for detecting a physical disturbance variable acting on the magnetic circuit device (4) is arranged on the magnetic circuit device (4), wherein the measuring magnetic field is influenced by the physical disturbance variable and wherein the control and evaluation unit (6) is designed such that it detects and signals an exceeding or falling below of a predefinable limit value of the physical disturbance variable

2. Magnetic-inductive flowmeter (1) according to claim 1, **characterized in that** the control and evaluation unit (6) is designed such that it performs a correction of the effect of the physical disturbance variable on the flow measurement.

3. Magnetic-inductive flowmeter (1) according to claim 1 or 2, **characterized in that** the sensor (7) is designed as a temperature sensor (8) and is used for detecting the temperature of the magnetic circuit device (4).

4. Magnetic-inductive flowmeter (1) according to claim 1 or 2, **characterized in that** the sensor (7) is designed as a magnetic field sensor (9) - in particular as a Hall sensor - and is used for detecting an external magnetic field acting on the magnetic circuit device (4).

5. Magnetic-inductive flowmeter (1) according to claim 1 or 2, **characterized in that** the sensor (7) is designed as a magnetic switch (10) and is used for detecting an external magnetic field acting on the magnetic circuit device (4).

6. Magnetic-inductive flowmeter (1) according to claim 1 or 2, **characterized in that** the sensor (7) is designed as an acceleration sensor (11) and is used for detecting an acceleration of the magnetic circuit device (4) - caused in particular by vibration.

7. Magnetic-inductive flowmeter (1) according to any one of claims 1 to 6, **characterized in that** at least one further sensor (7) is arranged on the magnetic circuit device (4), in particular wherein the further sensor (7) is designed as a temperature sensor (8), as a magnetic field sensor (9), as a magnetic switch (10), or as an acceleration sensor (11).

8. Magnetic-inductive flowmeter (1) according to claim 7, **characterized in that** at least three sensors (7) are arranged on the magnetic circuit device (4), wherein one sensor (7) is designed as a temperature sensor (8), another sensor (7) as an acceleration sensor (11) and a further sensor (7) as a magnetic field sensor (9) or magnetic field switch (10).

9. Magnetic-inductive flowmeter (1) according to any one of claims 1 to 8, **characterized in that** the sensor (7) or the sensors (7) is or are attached to the magnetic circuit device (4) by means of a sensor attachment element (13), in particular **in that** the sensor attachment element (13) is designed as a printed circuit board (14).

10. Magnetic-inductive flowmeter (1) according to claim 9, **characterized in that** the sensor attachment element (13) is configured as an angle (15) - in particular as a right angle.

11. Method for operating a magnetic-inductive flowmeter (1) with a measuring tube (2), with a magnetic field generator (3) for generating a measuring magnetic field passing through the measuring tube (2), with a magnetic circuit device (4) for guiding the measuring magnetic field outside the measuring tube (2), with electrodes (5) for detecting a flow-dependent electrical measuring voltage when the conductive medium flows through the measuring tube (2), and with an electronic control and evaluation unit (6), wherein a sensor (7) is arranged on the magnetic circuit device (4) for detecting a physical disturbance variable acting on the magnetic circuit device (4), wherein the measuring magnetic field is influenced by the physical disturbance variable,
wherein the physical disturbance variable acting on the magnetic circuit device is detected by the sensor (101),
wherein the physical disturbance variable is compared with a predetermined limit value (102) and wherein an error state is signaled when the limit value is exceeded or fallen below (103).

12. Method according to claim 11 or 12, **characterized in that** a correction of the effect of the physical disturbance variable on the flow measurement is carried out (105) in a further method step.

13. Method according to claim 10, **characterized in that** correction data for the correction of the magnetic-inductive flow measurement are stored in the control and evaluation unit (100),
wherein, when the sensor is designed as a temperature sensor, the correction data describe the dependence of the measuring voltage on the temperature of the magnetic circuit device, caused by the temperature dependence of the measuring magnetic field, and
wherein, when the sensor is designed as a magnetic field sensor, the correction data describe the dependence of the measuring voltage on the external magnetic field acting on the magnetic field device caused by the dependence of the measuring magnetic field on the external magnetic field acting on the magnetic field device.

14. Method according to claim 13, wherein the sensor is designed as a temperature sensor and wherein the temperature sensor detects the temperature of the magnetic circuit device, or wherein the sensor is designed as a magnetic field sensor and wherein the magnetic field sensor detects the external magnetic field at the magnetic circuit device, **characterized in that** the correction of the effect of the physical disturbance variable is implemented **in that** the detected electrical measuring voltage is corrected with the correction data when a conductive medium flows through the measuring tube.

15. Method according to claim 11 or 12, wherein the sensor is designed as an acceleration sensor and wherein the acceleration sensor detects the acceleration of the magnetic circuit device, wherein the acceleration is, in particular, due to vibrations of the magnetic circuit device, **characterized in that** the correction of the effect of the physical disturbance variable on the flow measurement is implemented **in that** the measuring frequency for detecting the electrical measuring voltage is selected such that the sampling period corresponds to a multiple of the vibration period.

16. Method according to claim 15, wherein the acceleration of the magnetic circuit device is a periodic vibration with a vibration amplitude and a vibration frequency and wherein the measuring signal has a periodic measuring signal oscillation, **characterized in that** the measuring signal frequency of the periodic measuring signal oscillation is determined (106), that the measuring signal frequency is compared with the vibration frequency (107) and that a correction of the effect of the physical disturbance variable on the flow measurement is carried out (105) when the measuring signal frequency corresponds to the vibration frequency of the magnetic circuit device or when the vibration frequency is included in the measuring signal oscillation.

## Revendications

1. Débitmètre magnéto-inductif (1) servant à mesurer le débit d'un fluide conducteur, comprenant un tube de mesure (2), un équipement de génération de champ magnétique (3) servant à générer un champ magnétique de mesure traversant le tube de mesure (2), un dispositif à circuit magnétique (4) servant à guider le champ magnétique de mesure à l'extérieur du tube de mesure (2), des électrodes (5) servant à détecter une tension de mesure électrique dépendante du débit lorsque le fluide conducteur est amené à passer par le tube de mesure (2), et un équipement électronique de commande et d'évaluation (6),
**caractérisé en ce qu'**un capteur (7) servant à détecter une grandeur physique perturbatrice agissant sur le dispositif à circuit magnétique (4) est disposé sur le dispositif à circuit magnétique (4), le champ magnétique de mesure étant affecté par la grandeur physique perturbatrice, et l'unité de commande et d'évaluation (6) étant conçue de telle sorte qu'elle identifie et signale un dépassement ou un soupassement d'une valeur limite prédéfinissable de la grandeur physique perturbatrice.

2. Débitmètre magnéto-inductif (1) selon la revendication 1, **caractérisé en ce que** l'unité de commande et d'évaluation (6) est conçue de telle sorte qu'elle effectue une correction de l'effet de la grandeur physique perturbatrice sur la mesure de débit.

3. Débitmètre magnéto-inductif (1) selon la revendication 1 ou 2, **caractérisé en ce que** le capteur (7) est conçu sous forme de capteur de température (8) et sert à détecter la température du dispositif à circuit magnétique (4).

4. Débitmètre magnéto-inductif (1) selon la revendication 1 ou 2, **caractérisé en ce que** le capteur (7) est conçu sous forme de capteur de champ magnétique (9) - en particulier de capteur à effet Hall - et sert à détecter un champ magnétique extérieur, agissant sur le dispositif à circuit magnétique (4).

5. Débitmètre magnéto-inductif (1) selon la revendication 1 ou 2, **caractérisé en ce que** le capteur (7) est réalisé sous forme de commutateur de champ magnétique (10) et sert à détecter un champ magnétique extérieur, agissant sur le dispositif à circuit magnétique (4).

6. Débitmètre magnéto-inductif (1) selon la revendication 1 ou 2, **caractérisé en ce que** le capteur (7) est conçu sous forme de capteur d'accélération (11) et sert à détecter une accélération - en particulier provoquée par des vibrations - du dispositif à circuit magnétique (4).

7. Débitmètre magnéto-inductif (1) selon l'une quelconque des revendications 1 à 6, **caractérisé en ce qu'**au moins un capteur supplémentaire (7) est disposé sur le dispositif à circuit magnétique (4), en particulier dans lequel le capteur supplémentaire (7) est conçu sous forme de capteur de température (8), de capteur de champ magnétique (9), de commutateur de champ magnétique (10) ou de capteur d'accélération (11) .

8. Débitmètre magnéto-inductif (1) selon la revendication 7, **caractérisé en ce qu'**au moins trois capteurs (7) sont disposés sur le dispositif à circuit magnétique (4), un capteur (7) étant conçu sous forme de capteur de température (8), un capteur supplémentaire (7) étant conçu sous forme de capteur d'accélération (11) et un capteur supplémentaire (7) étant conçu sous forme de capteur de champ magnétique (9) ou de commutateur de champ magnétique (10).

9. Débitmètre magnéto-inductif (1) selon l'une quelconque des revendications 1 à 8, **caractérisé en ce que** le capteur (7) ou les capteurs (7) est/sont fixé(s) au dispositif à circuit magnétique (4) au moyen d'un élément de fixation de capteur (13), en particulier **en ce que** l'élément de fixation de capteur (13) est réalisé sous forme de carte de circuits imprimés (14).

10. Débitmètre magnéto-inductif (1) selon la revendication 9, **caractérisé en ce que** l'élément de fixation de capteur (13) est réalisé sous forme d'équerre (15) - en particulier d'équerre à angle droit.

11. Procédé servant à faire fonctionner un débitmètre magnéto-inductif (1), comprenant un tube de mesure (2), un équipement de génération de champ magnétique (3) servant à générer un champ magnétique de mesure traversant le tube de mesure (2), un dispositif à circuit magnétique (4) servant à guider le champ magnétique de mesure à l'extérieur du tube de mesure (2), des électrodes (5) servant à détecter une tension de mesure électrique dépendante du débit lorsque le fluide conducteur est amené à passer par le tube de mesure (2), et un équipement électronique de commande et d'évaluation (6), un capteur (7) servant à détecter une grandeur physique perturbatrice agissant sur le dispositif à circuit magnétique (4) étant disposé sur le dispositif à circuit magnétique (4), le champ magnétique de mesure étant affecté par la grandeur physique perturbatrice,
le capteur détectant (101) la grandeur physique perturbatrice agissant sur le dispositif à circuit magnétique,
la grandeur physique perturbatrice étant comparée (102) avec une valeur limite prédéfinie, et un état d'erreur étant signalé (103) en cas de dépassement ou de soupassement de la valeur limite.

12. Procédé selon la revendication 11, **caractérisé en ce que** dans une étape de procédé supplémentaire, une correction de l'effet de la grandeur physique perturbatrice sur la mesure de débit est effectuée (105) .

13. Procédé selon la revendication 11 ou 12, **caractérisé en ce que** des données de correction pour corriger la mesure de débit magnéto-inductive sont stockées (100) dans l'unité de commande et d'évaluation,
dans lequel, si le capteur est réalisé sous forme de capteur de température, les données de correction décrivent la dépendance de la tension de mesure de la température du dispositif à circuit magnétique, provoquée par la dépendance de température du champ magnétique de mesure, et
dans lequel, si le capteur est réalisé sous forme de capteur de champ magnétique, les données de correction décrivent la dépendance de la tension de mesure du champ magnétique extérieur, agissant sur le dispositif à circuit magnétique, provoquée par la dépendance du champ magnétique de mesure du champ magnétique extérieur, agissant sur le dispositif à circuit magnétique.

14. Procédé selon la revendication 13, dans lequel le capteur est réalisé sous forme de capteur de température, et dans lequel le capteur de température détecte la température du dispositif à circuit magnétique, ou dans lequel le capteur est réalisé sous forme de capteur de champ magnétique, et dans lequel le capteur de champ magnétique détecte le champ magnétique extérieur au niveau du dispositif à circuit magnétique, **caractérisé en ce que** la correction de l'effet de la grandeur physique perturbatrice est réalisée **en ce que** la tension de mesure électrique détectée est corrigée par les données de correction lorsqu'un fluide conducteur est amené à passer par le tube de mesure.

15. Procédé selon la revendication 11 ou 12, dans lequel le capteur est réalisé sous forme de capteur d'accélération, et dans lequel le capteur d'accélération détecte l'accélération du dispositif à circuit magnétique, l'accélération étant due en particulier à des vibrations du dispositif à circuit magnétique, **caractérisé en ce que** la correction de l'effet de la grandeur physique perturbatrice sur la mesure de débit est réalisée **en ce que** la fréquence de mesure pour détecter la tension de mesure électrique est sélectionnée de telle sorte que la durée de période d'échantillonnage correspond à un multiple de la durée de période de vibration.

16. Procédé selon la revendication 15, dans lequel l'accélération du dispositif à circuit magnétique est une vibration périodique ayant une amplitude de vibration et une fréquence de vibration, et le signal de mesure présentant une oscillation de signal de mesure périodique, **caractérisé en ce que** la fréquence de signal de mesure de l'oscillation de signal de mesure périodique est déterminée (106), **en ce que** la fréquence de signal de mesure est comparée (107) avec la fréquence de vibration, et **en ce qu'**une correction de l'effet de la grandeur physique perturbatrice sur la mesure de débit est effectuée (105) si la fréquence de signal de mesure coïncide avec la fréquence de vibration du dispositif à circuit magnétique ou si la fréquence de vibration est comprise dans l'oscillation de signal de mesure.
